# EUROPEAN PATENT APPLICATION

(11) **EP 4 651 329 A1**
(43) Date of publication of application: **19.11.2025**
(21) Application number: 24175891.1
(22) Date of filing: 15.05.2024
(51) Int. Cl.: H02H 9/02, G01R 31/327, H03K 17/082, H02H 9/00, H02H 3/04, H02H 3/087, H03K 17/08

(54) **SEMICONDUCTOR PROTECTION DEVICE, ENERGY SOURCE SYSTEM WITH A SEMICONDUCTOR PROTECTION DEVICE AND AIRCRAFT WITH A SEMICONDUCTOR PROTECTION DEVICE**

(71) Applicant: Helmut-Schmidt-Universität, Universität der Bundeswehr Hamburg, 22043 Hamburg (DE)
(72) Inventor: Grumm, Florian, 22043 Hamburg (DE); Winterfeld, Kevin Alexander, 22043 Hamburg (DE); Schulz, Detlef, 22043 Hamburg (DE)
(74) Representative: RGTH

(57) **Abstract**

In order to provide a semiconductor protection device which can limit currents in electrical energy source systems and storage systems in the event of load changes and short circuits, and in which faults can be reliably identified, a semiconductor protection device (100) is proposed, comprising a central control unit (10), a switch unit (11), a switch control unit (12) for controlling the switch unit (11), a short-circuit detector (13) and a switching operation detector (14), wherein the short-circuit detector (13) is configured to send a short-circuit signal to the switch control unit (12) in the event of a short-circuit, wherein the switch control unit (12) is configured to interrupt the control of the switch unit (11) on receipt of a short-circuit signal, wherein it is further provided that the switch unit (11) comprises at least two independent switch trains (18a, 18b, 18c), that the switching operation detector (14) is configured to determine a voltage drop across the switch unit (11), and that the switch control unit (12) is configured to switch the switch trains (18a, 18b, 18c) independently of one another.

## Description

The present invention relates to a semiconductor protection device comprising a central control unit, a switch unit, a switch control unit for controlling the switch unit, a short-circuit detector and a switching operation detector.

Furthermore, the present invention relates to an energy source system comprising a semiconductor protection device and to an aircraft, in particular an airplane, with a semiconductor protection device.

### Technological background

Fuel cell systems can replace the APU (Auxiliary Power Unit) in electrical High Voltage DC Current (HVDC) systems in aircraft.

From DE 10 2011 087 015 B4, an energy supply system for an aircraft or spacecraft is known, with an energy source that generates a direct current or a direct voltage. The energy supply system comprises a converter which is coupled to the energy source and which is configured to convert the generated direct current or the generated direct voltage into an output current specified for the energy supply system or an output voltage specified for the energy supply system, a switching device which is configured to couple an output of the energy supply system to the converter or directly to the energy source depending on an electrical power requested at the energy supply system. A bypass device is provided, and the switching device is configured to couple the output of the energy supply system either indirectly to the energy source via the converter or directly to the energy source via the bypass device.

DE 10 2014 110 481 A1 discloses a protection device for electrical power supply networks in which at least one load can be supplied from at least one energy source. The protection device comprises at least one undervoltage monitoring device for detecting whether a DC measurement voltage derivable from a supply voltage which can be output by the at least one energy source falls below a first threshold value, at least one overvoltage monitoring device for detecting whether the DC measurement voltage exceeds a second threshold value, and at least one switching device for establishing an electrical connection between the at least one energy source and the at least one load, if the DC measurement voltage corresponds to at least the first and at most the second threshold value. The at least one undervoltage monitoring device, the at least one overvoltage monitoring device and the at least one switching device can be supplied exclusively from the supply voltage and/or the DC measurement voltage which can be output by the at least one energy source.

In energy source systems, especially in fuel cell systems, high surge short-circuit currents of several hundred amperes with a high time constant can occur in the event of a terminal short-circuit. These transient currents can damage components of the energy source system.

### Description of the invention: Task, solution, advantages

The invention is based on the task of providing a semiconductor protection device which can limit currents in electrical energy source systems and storage systems during load changes and short circuits, and in which faults can be reliably identified.

To solve the problem on which the invention is based, a semiconductor protection device is proposed, comprising a central control unit, a switch unit, a switch control unit for controlling the switch unit, a short-circuit detector and a switching operation detector, wherein the short-circuit detector is configured to send a short-circuit signal to the switch control unit in the event of a short-circuit, wherein the switch control unit is configured to interrupt the control of the switch unit when a short-circuit signal is received, wherein it is further provided that the switch unit comprises at least two independent switch trains, that the switching operation detector is configured to determine a voltage drop across the switch unit, and that the switch control unit is configured to switch the switch trains independently of one another.

According to the invention, it is thus provided that the semiconductor protection device has a short-circuit detector for short-circuit current detection and short-circuit current limitation, and that the switch unit has at least two independently switchable switch trains.

Due to the independent switchability of the switch trains by the switch control unit, it is possible to monitor and test the switching capability of the switch unit in conjunction with the switching operation detector. In particular, the possibility to self-test the switching capability of the switch unit is provided, without having to interrupt the supply to connected equipment.

The voltage drop is preferably determined by the switching operation detector, while the switch control unit switches the switch trains.

It is preferably provided that the switching operation detector is configured to transmit a voltage drop signal to the central control unit, and that the central control unit is configured to use the voltage drop signal to determine that the switch unit is defective.

The switching operation detector can be configured to identify whether a switch train is switched. If a switch train is no longer capable of switching, the switch unit is faulty. Depending on the voltage drop signal, the central control unit decides whether the switch unit is faulty. This self-test can be carried out without interrupting the load current. Only the resistance of the switch unit changes briefly when one or more switch trains are switched off.

It can further be provided that, if the switch unit is damaged, the central control unit sends a signal via an optical fiber to an electromechanical contactor or a relay to switch off the system. In this way, the semiconductor protection device can be protected. Fault analysis is also simplified.

Preferably, it can be provided that the central control unit determines that the switch unit is defective if the voltage drop signal indicates that no voltage drop has occurred and/or that the voltage is unchanged or constant.

If a switch train is defective, the switch voltage remains the same in the faulty state if the short-circuited switch train is switched. A defective switch unit can therefore be determined by measuring the voltage drop and evaluating a voltage drop signal.

Advantageously it can be provided that the switching operation detector comprises a lock-in amplifier.

To measure the voltage drop, the change in a differential voltage is determined. Here, the change in the differential voltage can be very small. To increase the signal-to-noise ratio, the switching operation detector can therefore comprise a lock-in amplifier.

With further advantage it can be provided that the switch control unit is configured to switch the switch trains alternately, in particular cyclically.

The cyclical switching of the switch trains allows the functionality of the switch unit to be tested without interrupting the load current. If a switch train is defective, the voltage remains the same when the short-circuited switch train is switched off. As explained above, the central control unit can determine a defect in the switch unit from a corresponding voltage drop signal.

Preferably, it is provided that the switch unit comprises at least three, preferably exactly three, switch trains.

This measure creates increased redundancy.

With further advantage, it can be provided that each switch train comprises two anti-serially connected MOSFETs (Metal Oxide Semiconductor Field-Effect Transistor).

MOSFETs have low losses due to their low contact resistance. MOSFETs are also highly reliable, as their susceptibility to mechanical stresses such as acceleration and vibrations is low. In addition, the number of switching cycles is higher and their switching times are much shorter than those of electromagnetic switches. One disadvantage of MOSFETs is that their current-carrying capacity is determined for the thermal contact resistances and capacitances in the application systems. Thus transient currents, such as those that occur in fuel cells, capacitor banks and battery systems in the event of short circuits, can destroy a MOSFET.

With the semiconductor protection device, whose switch control unit interrupts the control of the switch unit when a short-circuit signal is received, the MOSFETs provided in the preferred embodiment can be protected against overload.

It is particularly preferred that the switch trains do not have a common ground.

With further advantage, it may be provided that the switch control unit comprises a control module for each switch train, wherein each control module preferably comprises a galvanically separated voltage supply and an optically insulated driver LED.

Furthermore, it can be provided that all cathodes of the driver LEDs are connected to the ground of the voltage supply of the respective control module via a depletion MOSFET, preferably a depletion MOSFET of the switch control unit.

The depletion MOSFET conducts when there is no voltage between the gate and source. If the gate-source voltage is greater than the threshold voltage, the transistor blocks. No current flows through the LED of the drivers, the MOSFET of the switch unit block. The gate-source voltage required for blocking is preferably generated by the short-circuit detector.

Furthermore, it may be provided that a current-voltage transformer, preferably connected in series upstream of the switch unit, is provided, wherein the current-voltage transformer converts a current change per time di/dt into a proportional voltage signal U(di/dt), wherein the current-voltage transformer is configured to send the voltage signal to the short-circuit detector, and wherein the short-circuit detector is configured to send the short-circuit signal depending on the voltage signal.

Thus, preferably the short-circuit detection relies on the detection of a current change per time di/dt, whereby a short-circuit can be detected and in reaction the control of the switch unit interrupted, when a short-circuit signal is received before the unaffected short-circuit current flows. Because the unaffected short-circuit current does not flow the switch-off time can be very short, as the switch-off process does not cause an increased di/dt, which would cause overvoltages. Thus, a short circuit can be switched off with almost the rated current because it is recognized before it flows effectively.

The current-voltage transformer preferably has a power inductance and a rectifier.

The current-voltage transformer is preferably set up in such a way that in the event of a short circuit, a voltage drops across a power inductance of the current-voltage transformer. The voltage drop is dependent on the power inductance and the rate of change of current. A rectifier is preferably used to generate a direction-independent DC voltage. The voltage signal is preferably the direction-dependent DC voltage and serves as an input to the short-circuit detector.

Preferably, the short-circuit detector comprises an input filter for voltage smoothing and/or a comparator to which a reference voltage is preferably applied. Furthermore, the short-circuit detector can have an optocoupler, a shift register, a clock generator, an AND gate and/or a flip-flop.

The comparator compares the voltage signal smoothed by the input filter with a reference voltage. If the voltage of the power inductance exceeds the reference voltage, the comparator controls an optocoupler. This provides the galvanic insulation between the coil voltage and the switch control unit as well as the central control unit. The reference voltage and the comparator are preferably supplied by a galvanically insulated voltage supply. The output of the optocoupler is connected to a shift register that processes the signal from the optocoupler at a fixed clock frequency of the clock generator. If the high level of the comparator is present for the number of registers times the clock duration, a high signal is generated at the output of an AND gate. The shift register in combination with the AND gate prevents an unintentional response to short pulses that cannot be limited. The high level of the AND gate as an output signal sets a flip-flop. The flip-flop output blocks the depletion MOSFET of the switch control unit. The signal of the flip-flop also resets the central control unit. This enables a reaction from the central control unit, which monitors the current limitation via the current sensor.

Preferably, the semiconductor protection device comprises a current limiting unit, further preferably connected in parallel with the switch unit, wherein the switch control unit is further configured to activate the current limiting unit when a short-circuit signal is received.

Preferably, it can be provided that the current limiting unit has two anti-serially connected MOSFETs and preferably power resistors and/or a fuse and/or NTC thermistors and/or a varistor for current limiting.

By means of the power resistor the inrush current can be limited for a defined time interval by absorbing energy.

Alternatively or in addition to the resistors, a fuse, an NTC thermistor or a varistor can also be provided for current limiting.

Preferably, the current limiting unit is also switched on or off by the switch control unit.

A further solution to the problem underlying the invention consists in an energy source system comprising an electrical energy source and a semiconductor protection device as described above.

Preferably, the electrical energy source is a fuel cell.

With further advantage it can be provided that the energy source system has a mains protection.

A still further solution to the problem underlying the invention consists in an aircraft, in particular an airplane, with an energy source system as described above.

All of the features, functions and configurations described above with regard to the semiconductor protection device can also be transferred to the energy source system or the aircraft in a correspondingly analogous manner.

The semiconductor protection device can be used to protect against high transient currents in electrical systems or energy sources such as fuel cell systems, capacitors and battery systems. The semiconductor protection device can also be used in a modular manner within low-voltage networks.

The semiconductor protection device can limit the current during load changes and short circuits within electrical systems and storage units. In particular, the semiconductor protection device can limit the charging and discharging current of electrochemical double-layer capacitors.

The semiconductor protection device is therefore particularly suitable for the protection and operation of short-term storage systems based on electrochemical double-layer capacitors in aircraft cabin networks. In particular, the semiconductor protection device can protect against high transient currents of a fuel cell system in the event of a saturated short circuit.

Due to the active current limitation, it is possible to ensure selective triggering of the semiconductor protection device within electrical systems with decentralized energy sources and low system impedances.

In battery storage systems in particular, the semiconductor protection device can establish selectivity within a system consisting of several parallel battery modules in the event of a short circuit if it is connected in series to a fuse. Battery storage systems consist of several battery racks connected in parallel. These in turn consist of battery modules connected in series. Individual battery cells are connected in series within the battery modules. Each rack possesses its own safety fuse to protect the operating equipment. If a short circuit occurs within a battery rack, the fuses in each rack are triggered simultaneously. This is because the contact, connection and internal resistances are so low in such systems that there is no selectivity between the rack fuses of the parallel battery racks. This selectivity is necessary to disconnect defective battery modules of the storage system if they are short-circuited. The semiconductor protection device can act as a switch for the battery management system.

Due to the short-circuit current limitation, the semiconductor protection device can be used in electrical systems that can be temporarily decoupled from the public power supply. In decoupled stand-alone operation, the short-circuit current is much lower than in coupled operation, so it may be necessary to adjust the protection parameters. The semiconductor protection device can be flexibly adapted to the operating state.

Thanks to the self-test, the semiconductor protection device can also be used for critical infrastructures. The short-circuit current limitation is advantageous for the high short-circuit currents that can occur in the coupled state.

The switching capability of the switch unit is permanently determined in real time without interrupting the current flow. Faults can be detected without interrupting the load and switched off via an external signal with an additional contactor. This method increases the detectability of faults and thus increases the reliability of the overall system. Short-circuit detection enables the parallel semiconductor trains to be interrupted by switching off the power supply to the individual gate drivers via the active blocking of a depletion MOSFET. Active blocking compared to active opening with a MOSFET reduces the power loss of the circuit, as the driver is only active during current transients.

### Brief description of the figures

The invention is explained in more detail below with reference to the attached figures.
- Fig. 1: shows a semiconductor protection device,
- Fig. 2: shows a switch unit of the semiconductor protection device,
- Fig. 3: shows a current-voltage transformer and a short-circuit detector of the semiconductor protection device,
- Fig. 4: shows a switch control unit of the semiconductor protection device,
- Fig. 5: shows a current limiting unit of the semiconductor protection device,
- Fig. 6: shows a switching operation detector of the semiconductor protection device,
- Fig. 7: shows an energy source system with a semiconductor protection device, and
- Fig. 8: shows an aircraft with an energy source system.

### Detailed description of the figures

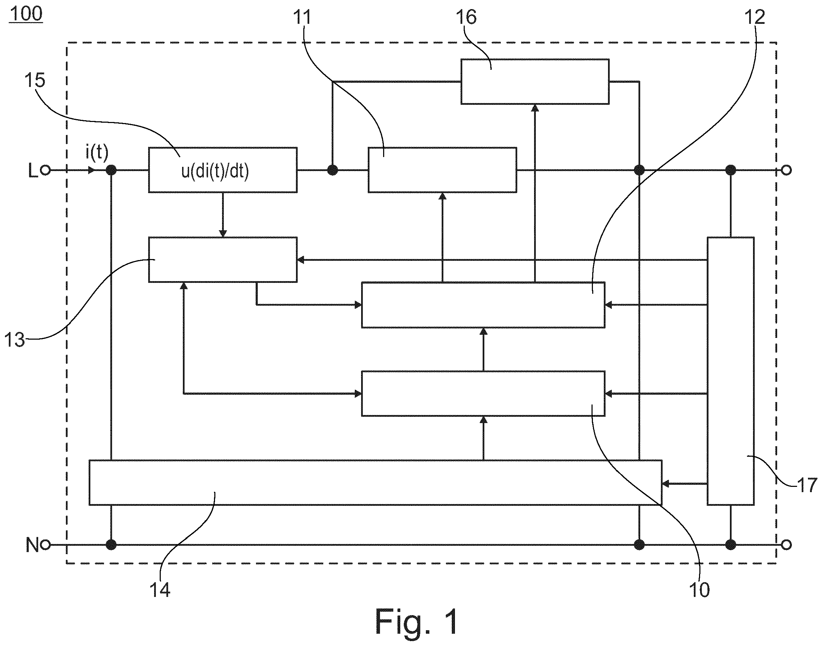

Fig. 1 shows a schematic representation of a semiconductor protection device 100. The semiconductor protection device 100 comprises a central control unit 10, a switch unit 11, a switch control unit 12 for controlling the switch unit 11, a short-circuit detector 13 and a switching operation detector 14. Further, the semiconductor protection device 100 comprises a current-voltage transformer 15, which is connected in series upstream of the switch unit 11, and a current limiting unit 16 connected in parallel with the switch unit 11. The semiconductor protection device 100 also has a central voltage supply 17.

By means of the semiconductor protection device 100 shown, an independent short-circuit current detection and short-circuit current limitation can be provided. It is also possible to monitor and test the switching capability of the switch unit 11 without interrupting the supply to connected equipment.

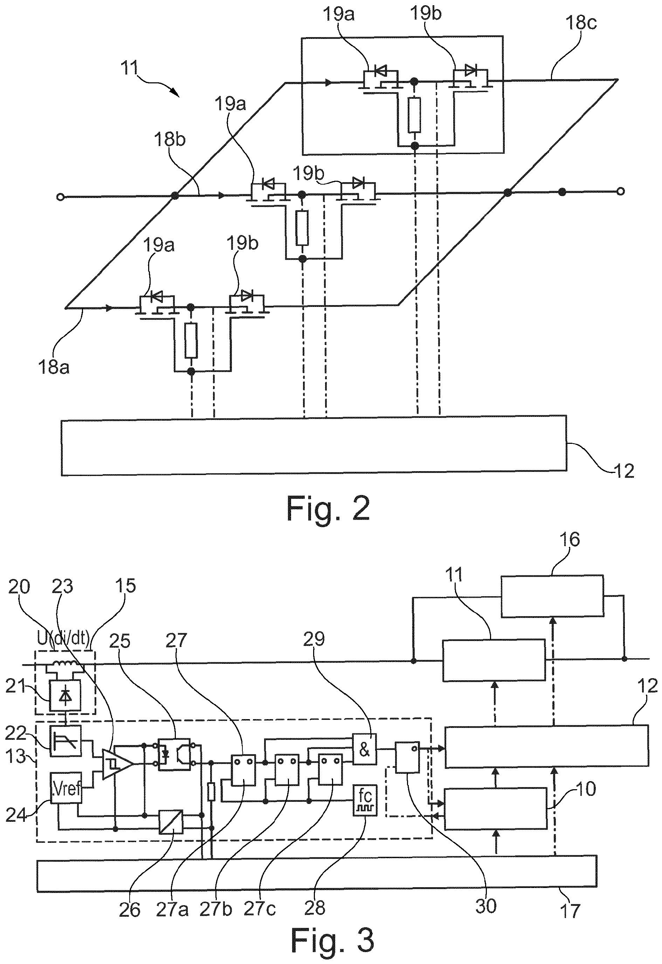

Fig. 2 shows the structure of the switch unit 11. In the case shown, the switch unit 11 comprises three parallel switch trains 18a, 18b, 18c. Each switch train 18a, 18b, 18c comprises two anti-serially connected MOSFETs 19a, 19b. It is provided that each of the switch trains 18a, 18b, 18c can be controlled individually by the switch control unit 12. The total resistance of the switch unit 11 changes when a switch train 18a, 18b, 18c is switched on or off.

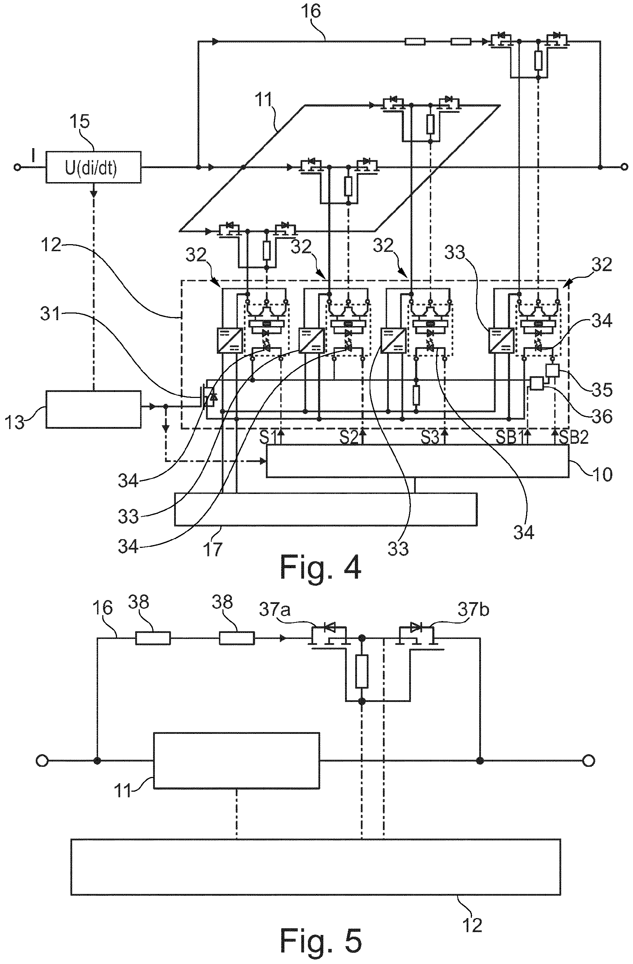

Fig. 3 shows the structure of the current-voltage transformer 15 and the short-circuit detector 13. The current-voltage transformer 15 converts a current change per time di/dt into a proportional voltage signal U(di/dt). The current-voltage transformer 15 comprises a power inductance 20 and a rectifier 21. In the event of a short circuit, the voltage drops across the power inductance 20. The rectifier 21 generates a direction-dependent DC voltage. The direction-dependent DC voltage is fed to the short-circuit detector 13 as a voltage signal. Within the short-circuit detector 13, an input filter 22 smoothes the voltage signal in order to suppress unwanted transients. A comparator 23 compares the smoothed voltage signal with a reference voltage 24. If the voltage signal of the power inductance 20 exceeds the reference voltage 24, the comparator 23 controls an optocoupler 25. This provides galvanic insulation between the voltage of the power inductance 20 and the switch control unit 12 as well as the central control unit 10. The reference voltage 24 and the comparator 23 are supplied by a galvanically insulated voltage supply 26. The output of the optocoupler 25 is connected to a shift register 27, which processes the signal of the optocoupler 25 at a fixed clock frequency f_{c} of a clock generator 28. If the high level of the comparator 23 is present for the number of registers 27a, 27b, 27c of the shift register 27 times the clock duration, a high signal is generated at the output of an AND gate 29. The shift register 27 in combination with the AND gate 29 prevents an unintentional response to short pulses that cannot be limited. The high level of the AND gate 29 as an output signal sets a flip-flop 30. The flip-flop output blocks a depletion MOSFET 31 of the switch control unit 12 (Fig. 4). Furthermore, the signal of the flip-flop 30 resets the central control unit 10. This enables a reaction of the control unit 10, which monitors the current limiting unit 16.

The short-circuit detection thus relies on the detection of a current change per time di/dt. A short-circuit signal can be detected before the unaffected short-circuit current flows. Thus, the switch-off time can be very short, as the switch-off process does not cause an increased di/dt, which would cause overvoltages. A short circuit can be switched off with almost the rated current because it is recognized before it flows effectively.

In the event of a short-circuit, the short-circuit detector 13 sends a short-circuit signal to the switch control unit 12. The switch control unit 12 is shown in Fig. 4. The switch control unit 12 comprises a control module 32 for each switch train 18a, 18b, 18c and for the current limiting unit 16. Each control module 32 comprises a galvanically separated voltage supply 33 and an optically insulated driver LED 34. All cathodes of the driver LEDs 34 are connected to the ground of the voltage supply 17 via the depletion MOSFET 31. The depletion MOSFET 31 conducts when there is no voltage between the gate and source. If the gate-source voltage is greater than a threshold voltage, the depletion MOSFET 31 blocks. No current flows through the driver LEDs 34. The MOSFETs 19a, 19b of the switch unit 11 block. The gate-source voltage required for blocking is generated by the short-circuit detector 13.

An AND gate 35 and an OR gate 36 determine the current through the driver LED 34 of the current limiting unit 16 (Fig. 5). If the signal SB2 is logically "TRUE", the current limiting unit 16 switches on when the depletion MOSFET 31 blocks, as the pull-up resistor generates a voltage that corresponds to a logical one at the input of the OR gate 36. The AND gate 35 prevents the current limiting unit 16 from being switched on unintentionally if a short circuit is detected. Only the central control unit 10 releases the short-circuit limitation with the signal SB2. With the signal SB1, the current limiting unit 16 can be activated for switch-on processes independently of the short-circuit detector 13.

Fig. 5 shows the current limiting unit 16. The current limiting unit 16 is connected in parallel with the switch unit 11 and consists of two anti-serially connected MOSFETs 37a, 37b and power resistors 38, which can limit the inrush current for a defined time interval by absorbing energy.

The semiconductor protection device 100 can be used not only to limit short-circuit currents, but also to perform a self-test of the switch unit 11 without interrupting the load. The prerequisite for this is that the switch unit 11 has at least two parallel switch trains 18a, 18b, 18c, wherein two MOSFETs 19a, 19b are anti-serially connected in each switch train 18a, 18b, 18c. The switch trains 18a, 18b, 18c can be individually switched on and off cyclically via the central control unit 10 and the switch control unit 12. In this way, the voltage drop across the switch unit 11 changes. In the faulty state, the switch voltage remains the same when a short-circuited switch train 18a, 18b, 18c is switched off.

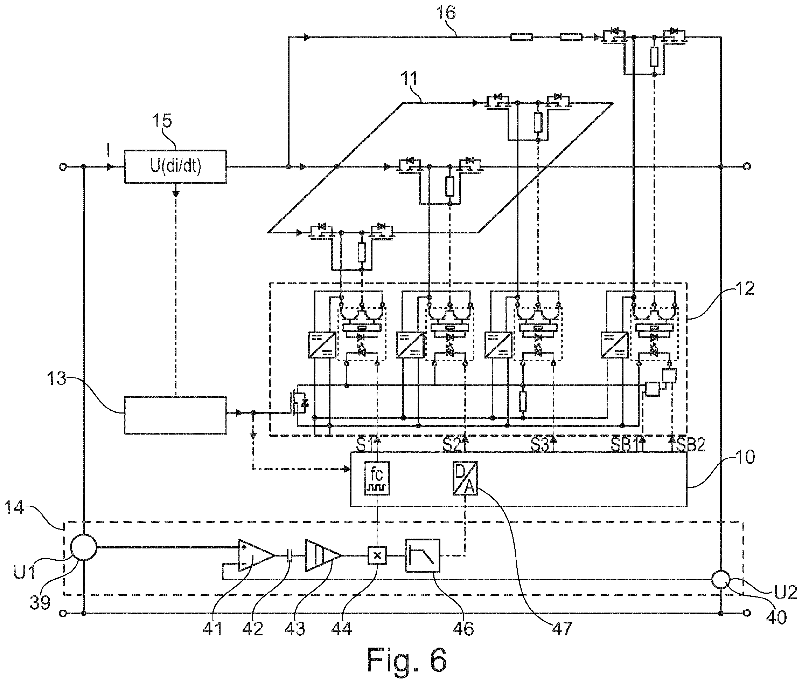

Fig. 6 schematically shows the switching operation detector 14. The switch voltage is determined from the voltage differences U1 and U2. Since the change in the differential voltage is only very small, the principle of the lock-in amplifier is used here to increase the signal-to-noise ratio. A subtractor 41 forms the voltage difference of the voltage sensors 39, 40. A capacitor 42 decouples the DC component of the signal. An insulation amplifier 43 is optional if the voltage sensors 39, 40 are not galvanically separated. A multiplier 44 multiplies the alternating signal of the voltage difference by a reference signal, which is generated by a clock generator 45 of the central control unit 10. The reference signal is standardized and corresponds to the control signal of a switch train 18a. The signal multiplication is filtered with a low-pass filter 46. The filtered signal corresponds approximately to the amplitude of the changing switch voltage. An AD converter 47 of the central control unit 10 can process the filtered signal and use it to determine whether the switch is defective.

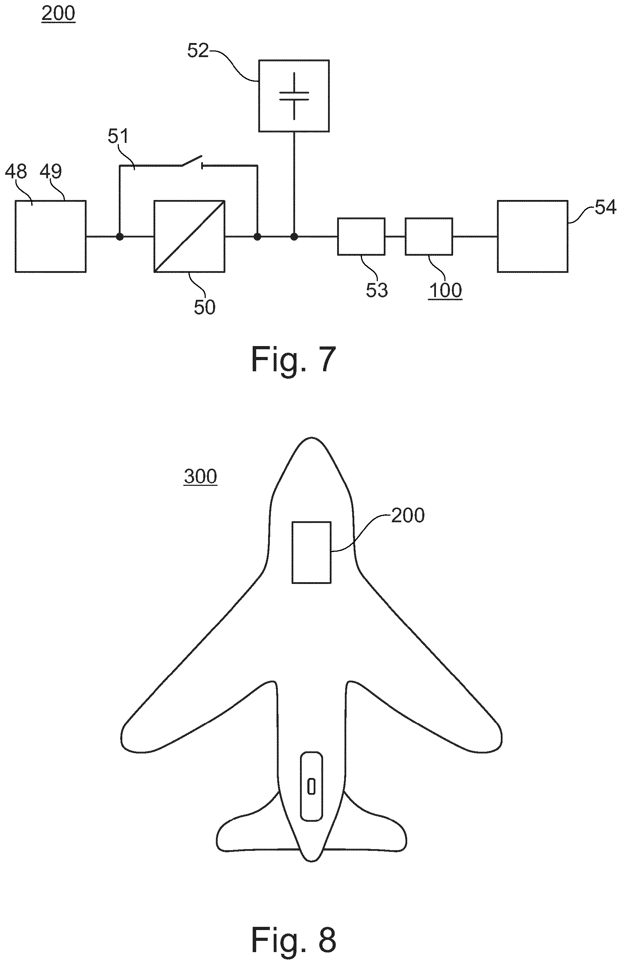

Fig. 7 shows an energy source system 200 with a semiconductor protection device 100. The energy source system 200 comprises a fuel cell 48 as an energy source 49, as well as a voltage supply 50, a bypass 51 and an energy storage 52. Furthermore, the energy source system 200 has a mains protection 53. The energy source system is configured to supply an energy grid 54.

Fig. 8 shows an aircraft 300, which is configured as an airplane 55. The aircraft 300 comprises an energy source system 200 according to Fig. 7.

### List of reference signs

- 100: Semiconductor protection device
- 200: Energy source system
- 300: Aircraft

- 10: Central control unit
- 11: Switch unit
- 12: Switch control unit
- 13: Short-circuit detector
- 14: Switching operation detector
- 15: Current-voltage transformer
- 16: Current limiting unit
- 17: Central voltage supply
- 18a: Switch train
- 18b: Switch train
- 18c: Switch train
- 19a: MOSFET
- 19b: MOSFET
- 20: Power inductance
- 21: Rectifier
- 22: Input filter
- 23: Comparator
- 24: Reference voltage
- 25: Optocoupler
- 26: Galvanically insulated voltage supply
- 27: Shift register
- 27a: Register
- 27b: Register
- 27c: Register
- 28: Clock generator
- 29: And gate
- 30: Flip-flop
- 31: Depletion MOSFET
- 32: Control module
- 33: Galvanically separated voltage supply
- 34: Driver LED
- 35: AND gate
- 36: OR gate
- 37a: MOSFET
- 37b: MOSFET
- 38: Power resistor
- 39: Voltage sensor
- 40: Voltage sensor
- 41: Subtractor
- 42: Condenser
- 43: Insulation amplifier
- 44: Multiplier
- 45: Clock generator
- 46: Low pass
- 47: AD converter
- 48: Fuel cell
- 49: Energy source
- 50: Voltage supply
- 51: Bypass
- 52: Energy storage
- 53: Mains protection
- 54: Energy grid
- 55: Aircraft

## Claims

1. Semiconductor protection device (100), comprising a central control unit (10), a switch unit (11), a switch control unit (12) for controlling the switch unit (11), a short-circuit detector (13) and a switching operation detector (14), wherein the short-circuit detector (13) is configured to send a short-circuit signal to the switch control unit (12) in the event of a short-circuit, wherein the switch control unit (12) is configured to interrupt the control of the switch unit (11) when a short-circuit signal is received, **characterized in that** the switch unit (11) comprises at least two independent switch trains (18a, 18b, 18c), **in that** the switching operation detector (14) is configured to determine a voltage drop across the switch unit (11), and **in that** the switch control unit (12) is configured to switch the switch trains (18a, 18b, 18c) independently of one another.

2. Semiconductor protection device (100) according to claim 1, **characterized in that** the switching operation detector (14) is configured to transmit a voltage drop signal to the central control unit (10), and **in that** the central control unit (10) is configured to use the voltage drop signal to determine that the switch unit (11) is defective.

3. Semiconductor protection device (100) according to claim 1 or 2, **characterized in that** the switching operation detector (14) comprises a lock-in amplifier.

4. Semiconductor protection device (100) according to one of the aforementioned claims, **characterized in that** the switch control unit (12) is configured to switch the switch trains (18a, 18b, 18c) alternately, in particular cyclically.

5. Semiconductor protection device (100) according to one of the aforementioned claims, **characterized in that** the switch unit (11) comprises at least three, preferably exactly three, switch trains (18a, 18b, 18c).

6. Semiconductor protection device (100) according to one of the aforementioned claims, **characterized in that** each switch train (18a, 18b, 18c) comprises two anti-serially connected MOSFETs (19a, 19b).

7. Semiconductor protection device (100) according to one of the aforementioned claims, **characterized in that** the switch trains (18a, 18b, 18c) do not have a common ground.

8. Semiconductor protection device (100) according to one of the aforementioned claims, **characterized in that** the switch control unit (12) comprises a control module (32) for each switch train (18a, 18b, 18c), each control module (32) preferably comprising a galvanically separated voltage supply (33) and an optically insulated driver LED (34).

9. Semiconductor protection device (100) according to claim 8, **characterized in that** all cathodes of the driver LEDs (34) are connected via a depletion MOSFET (31), in particular a depletion MOSFET (31) of the switch control unit (12), to the ground of the voltage supply (33) of the respective control module (32).

10. Semiconductor protection device (100) according to one of the aforementioned claims, **characterized in that** a current-voltage transformer (15), preferably connected in series upstream of the switch unit (11), is provided, wherein the current-voltage transformer (15) converts a current change per time di/dt into a proportional voltage signal U(di/dt), wherein the current-voltage transformer (15) is configured to send the voltage signal to the short-circuit detector (13), and wherein the short-circuit detector (13) is configured to send the short-circuit signal depending on the voltage signal.

11. Semiconductor protection device (100) according to one of the aforementioned claims, further comprising a current limiting unit (16), preferably connected in parallel with the switch unit (11), **characterized in that** the switch control unit (12) is further configured to activate the current limiting unit (16) upon receipt of a short-circuit signal.

12. Semiconductor protection device (100) according to claim 11, **characterized in that** the current limiting unit (16) has two anti-serially connected MOSFETs (37a, 37b) and preferably power resistors (38) and/or a fuse and/or NTC thermistors and/or a varistor for current limiting.

13. An energy source system (200) comprising an electrical energy source (49) and a semiconductor protection device (100) according to any one of the aforementioned claims.

14. Energy source system (200) according to claim 13, **characterized in that** the electrical energy source (49) is a fuel cell (48), and/or **in that** the energy source system has a mains protection (53).

15. Aircraft (300), in particular an airplane (55), with an energy source system (200) according to claim 13 or 14.
